# FASCICULE DE BREVET EUROPEEN

(11) **EP 4 147 544 B1**
(45) Date de publication et mention de la délivrance du brevet: **27.09.2023**
(21) Numéro de dépôt: 21719134.5
(22) Date de dépôt: 16.04.2021
(51) Int. Cl.: H05K 7/14, H02B 11/127, H02B 3/00

(54) **PROCEDE D'INSTALLATION D'UN MODULE DE COMMUTATION DANS UNE ARMOIRE ELECTRIQUE, KIT D'INSTALLATION ET MODULE DE COMMUTATION CORRESPONDANTS**
VERFAHREN ZUR INSTALLATION EINES SCHALTMODULS IN EINEM SCHALTSCHRANK, ENTSPRECHENDER INSTALLATIONSBAUSATZ UND SCHALTMODUL
METHOD FOR INSTALLING A SWITCHING MODULE IN AN ELECTRICAL CABINET, CORRESPONDING INSTALLATION KIT AND SWITCHING MODULE

(30) Priorité: 05.05.2020 FR 2004457
(43) Date de publication de la demande: 15.03.2023
(73) Titulaire: Socomec S.A., 67230 Benfeld (FR)
(72) Inventeur: HUBER, Lionel, 67680 EPFIG (FR); BIEGEL, Pierre, 67730 CHATENOIS (FR); BILDSTEIN, David, 67115 PLOBSHEIM (FR); STAMMITTI, Claudio, GUELPH, Ontario N1E 7G4 ON (CA); FARIA, Desmond, Richmond Hill, Ontario L4C 5C3 ON (CA)
(74) Mandataire: Cabinet Laurent & Charras
(86) Numéro de dépôt international: PCT/EP2021/059900
(87) Numéro de publication internationale: WO 2021/223979

(56) Documents cités:
- JP-A- 2003 259 512
- JP-U- S5 960 805
- JP-U- S58 195 476
- US-A- 3 483 338

## Description

### Domaine technique :

La présente invention concerne un procédé d'installation d'un module de commutation lourd et encombrant, notamment un commutateur de transfert statique (STS), dans une armoire électrique, un kit d'installation et un module de commutation permettant la mise en oeuvre dudit procédé.

### Technique antérieure :

Les modules de commutation auxquels s'intéresse la présente invention concernent principalement des modules volumineux (de l'ordre du mètre cube) et lourds (de 200 à 300 kg, voire jusqu'à 500 kg selon les modèles), destinés à la commutation des fortes puissances (plage de courant de 200 à 1800 A). Ces chiffres ne sont donnés qu'à titre indicatif et n'ont pas d'effet limitatif. Ces modules de commutation peuvent être des commutateurs simples comprenant une entrée et une sortie de courant, ou des commutateurs de transfert comprenant deux entrées et une sortie de courant, les deux entrées de courant provenant de deux sources d'énergie indépendantes, une source dite principale et une source dite de secours ou alternative. La présente invention s'intéresse plus particulièrement aux commutateurs de transfert, plus connus sous la dénomination « Système de Transfert Statique » et sous le sigle STS (Static Transfer Switch). Les systèmes de transfert statique (STS) sont des commutateurs intelligents qui transfèrent les charges vers une source auxiliaire ou de secours lorsque la source principale est défaillante ou en maintenance pour une longue durée. Ils utilisent de l'électronique de puissance permettant une commutation rapide d'une source à l'autre pour garantir une continuité d'alimentation. Ils garantissent ainsi une souplesse de maintenance d'un site ou d'une installation, ainsi qu'une disponibilité élevée, même en cas d'indisponibilité du réseau d'alimentation électrique. Ces systèmes STS conviennent en particulier à des infrastructures évoluant dans de nombreux secteurs tels que la finance, la banque et l'assurance, le domaine de la santé, la télécommunication et la radio télédiffusion, l'industrie, les centrales électriques, le transport, etc.

D'une manière traditionnelle, les modules de commutation de ce type sont intégrés dans les armoires électriques lors de leur fabrication. Ce type d'installation est contraignante lorsqu'il faut procéder à des opérations de maintenance et/ou au remplacement d'un module défectueux par un nouveau module. Leur encombrement et surtout leur poids, quelques centaines de kilogrammes, nécessitent des moyens de manutention conséquents, notamment des engins de levage, ponts roulants, chariots élévateurs, gerbeurs ou similaires, pour démonter le module défectueux et l'extraire de l'armoire, pour le manutentionner à l'extérieur de l'armoire, puis pour installer le module réparé ou un nouveau module et le remonter dans l'armoire. Cette manutention lourde monopolise plusieurs opérateurs et des engins de levage adaptés, nécessite plusieurs heures de travail, et n'est pas sans risque ni pour le personnel, ni pour le matériel.

Une des solutions connues, décrite dans la publication JP 2003 259512 A, consiste à ajouter des roulettes sous le module électrique pour faciliter son déplacement par poussée et traction dans un plan de transfert qui s'étend de l'extérieur vers l'intérieur de l'armoire électrique et inversement. Une des solutions complémentaires, décrite dans les publications JP S59 60805 U et US 3 483 338 A, consiste à prévoir des rails de support extensibles dans l'armoire électrique pour créer des chemins de roulement s'étendant de l'extérieur vers l'intérieur de l'armoire facilitant le déplacement du module électrique par rapport à l'armoire. Néanmoins, dans tous les cas et si le module électrique est lourd, interdisant une manutention manuelle comme dans la publication JP S58 195476 U, le recours à des moyens de manutention conséquents, tels que des engins de levage, est indispensable.

### Présentation de l'invention :

La présente invention vise à pallier ces inconvénients en proposant un procédé pour installer un module de commutation dans une armoire électrique de manière amovible pour qu'il soit interchangeable, dans le but de faciliter les interventions en cas de panne ou de maintenance, de raccourcir le temps d'intervention, d'améliorer l'ergonomie, de sécuriser le travail des opérateurs, de garantir l'intégrité du matériel, sans avoir à monopoliser plusieurs opérateurs, ni des moyens de manutention conséquents comme des engins de levage.

Dans ce but, l'invention concerne un procédé du genre indiqué en préambule, dans lequel l'on installe ledit module de commutation dans ladite armoire électrique au moyen d'un kit d'installation pour rendre ledit module de commutation facilement démontable et interchangeable, quel que soit son encombrement et son poids, et éviter le recours à un engin de levage, dans lequel l'on équipe ladite armoire électrique avec ledit kit d'installation comportant deux rails de support extensibles entre une position étendue à l'extérieur de ladite armoire électrique et une position rétractée à l'intérieur de ladite armoire électrique, lesdits rails de support étant agencés pour former deux chemins de roulement parallèles, dans lequel l'on équipe ledit module de commutation avec des roulettes disposées en deux rangées parallèles, agencées pour circuler sur lesdits chemins de roulement de manière à pouvoir déplacer ledit module de commutation de l'extérieur vers l'intérieur de ladite armoire électrique et inversement par poussée et traction avec un minimum d'efforts, et dans lequel l'on utilise une palette de transport rehaussée faisant partie dudit kit d'installation, pour manutentionner ledit module de commutation en dehors de ladite armoire électrique au moyen d'un chariot de manutention, de sorte que les roulettes dudit module de commutation, lorsqu'il est pris en charge par ladite palette de transport, sont positionnées sensiblement au même niveau que les chemins de roulement définis par lesdits rails de support pour permettre le transfert dudit module de commutation par roulement de la palette de transport à l'armoire électrique et inversement.

L'on peut équiper ladite palette de transport de longerons, l'on peut fixer ledit module de commutation sur lesdits longerons au moyen de pieds disposés sous ledit module de commutation entre les deux rangées de roulettes, et l'on peut déterminer la hauteur desdits longerons en fonction du niveau d'installation desdits rails de support dans ladite armoire électrique.

Dans une forme préférée de l'invention, l'on prévoit dans ledit kit d'installation une plage de raccordement distale et une plage de raccordement latérale formant deux plans d'appui verticaux perpendiculaires, l'on fixe lesdites plages de raccordement dans ladite armoire électrique respectivement sur une face arrière et sur une des faces latérales intérieures de ladite armoire électrique, l'on y raccorde des conducteurs électriques formant des entrées et des sorties du courant, et l'on équipe ledit module de commutation de bornes de raccordement distales et des bornes de raccordement latérales formant deux plans d'appui verticaux perpendiculaires. Avantageusement, l'on fixe ladite plage de raccordement latérale sur des étriers pour qu'elle soit mobile entre une position initiale correspondant à une position connectée avec les bornes de raccordement latérales dudit module de commutation, et une position escamotée correspondant à une position déconnectée desdites bornes de raccordement latérales en ménageant un jeu de montage qui autorise le déplacement dudit module de commutation par rapport à ladite armoire électrique.

L'on peut également prévoir dans ledit kit d'installation des pattes de fixation latérales rapportées sur les faces latérales intérieures de ladite armoire électrique, l'on peut équiper ledit module de commutation de pattes de fixation frontales, et, lorsque ledit module de commutation est en position montée dans ladite armoire électrique, on peut le verrouiller en position montée, en fixant les pattes de fixation frontales sur les pattes de fixation latérales correspondantes prévues dans l'armoire électrique.

Dans ce but, l'invention concerne également un kit d'installation, caractérisé en ce qu'il comporte deux rails de support agencés pour équiper ladite armoire électrique, lesdits rails de support étant extensibles entre une position étendue et une position rétractée pour former deux chemins de roulement parallèles pour ledit module de commutation, et en ce qu'il comporte une palette de transport rehaussée agencée pour manutentionner ledit module de commutation en dehors de ladite armoire électrique au moyen d'un chariot de manutention, sans avoir recours à un engin de levage.

Ladite palette de transport peut comporter deux longerons sur lesquels est destiné à être fixé ledit module de commutation, et lesdits longerons peuvent avoir une hauteur déterminée en fonction du niveau d'installation des rails de support dans ladite armoire électrique.

Dans une forme de réalisation préférée, le kit d'installation comporte une plage de raccordement distale et une plage de raccordement latérale formant deux plans d'appui verticaux perpendiculaires, lesdites plages de raccordement étant agencées pour équiper ladite armoire électrique. Avantageusement, ladite plage de raccordement latérale peut être montée sur des étriers pour être mobile entre une position initiale et une position escamotée, séparées entre-elles d'un jeu de montage.

Le kit d'installation peut en outre comporter des pattes de fixation latérales agencées pour équiper ladite armoire électrique et verrouiller ledit module de commutation en position montée lorsqu'il est installé dans ladite armoire électrique.

Dans ce but, l'invention concerne enfin un module de commutation, caractérisé en ce qu'il comporte des roulettes disposées en deux rangées parallèles et agencées pour circuler sur des chemins de roulement formés par des rails de support extensibles rapportés dans ladite armoire électrique, et des pieds disposés sous ledit module et agencés pour fixer ledit module de commutation sur une palette de transport, lesdits pieds pouvant être disposés entre lesdites rangées de roulettes.

Dans une forme préférée de l'invention, ledit module de commutation comporte des bornes de raccordement distales et des bornes de raccordement latérales saillantes en partie supérieure dudit module et disposées pour former deux plans d'appui verticaux perpendiculaires, lesdites bornes de raccordement étant agencées pour être connectées aux plages de raccordement distale et latérale rapportées dans ladite armoire électrique lorsque ledit module de commutation est installé dans ladite armoire électrique.

Enfin, il peut comporter des pattes de fixation frontales agencées pour être assemblées à des pattes de fixation latérales correspondantes rapportées dans ladite armoire électrique lorsque ledit module de commutation est installé dans ladite armoire électrique.

### Brève description des figures :

La présente invention et ses avantages apparaîtront mieux dans la description suivante de plusieurs modes de réalisation donnés à titre d'exemples non limitatifs, en référence aux dessins annexés, dans lesquels:
- la figure 1 est une vue en perspective d'un module de commutation selon l'invention fixé sur une palette de transport faisant partie d'un kit d'installation selon l'invention,
- la figure 2 est une vue éclatée en perspective d'un kit d'installation selon l'invention,
- la figure 3 est une vue en perspective d'une armoire électrique équipée d'une partie du kit d'installation illustré à la figure 2,
- la figure 4 est une vue de détail d'un rail de support extensible du kit d'installation monté dans l'armoire électrique de la figure 3, en position étendue,
- la figure 5 est une vue en perspective illustrant une étape du procédé d'installation selon l'invention, dans laquelle on transfère le module de commutation de la palette de transport à l'armoire électrique,
- la figure 6 est une vue de face de l'armoire électrique dans laquelle le module de commutation a été introduit à l'issue de l'étape de la figure 5,
- la figure 7 est une vue en perspective de la figure 6, montrant les rails de support extensibles en position étendue, et la palette de transport retirée,

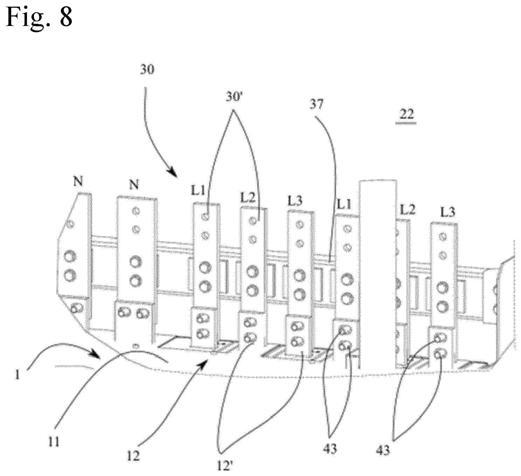

- la figure 8 est une vue de détail montrant une étape de connexion entre des bornes de raccordement arrière du module de commutation et des plages de raccordement arrière de l'armoire électrique,
- la figure 9 est une vue de détail montrant une étape préalable à la connexion entre des bornes de raccordement latérales du module de commutation et des plages de raccordement latérales de l'armoire électrique,
- la figure 10 est une vue de dessus de la figure 9,
- la figure 11 est une vue de détail de la figure 10 d'une borne de raccordement et d'une plage de raccordement éloignées d'un jeu de montage,
- la figure 12 est une vue de détail similaire à la figure 9 montrant l'étape de connexion entre les bornes de raccordement latérales du module de commutation et les plages de raccordement latérales de l'armoire électrique,
- la figure 14 est une vue de détail de la figure 13 d'une borne de raccordement et d'une plage de raccordement connectées.

### Description détaillée de l'invention :

Dans l'exemple de réalisation illustré, les éléments ou parties identiques portent les mêmes numéros de référence. En outre, les termes qui ont un sens relatif, tels que vertical, horizontal, droite, gauche, avant, arrière, au-dessus, en-dessous, supérieur, inférieur, latéral, transversal, etc. doivent être interprétés dans des conditions normales d'utilisation de l'invention, telles que représentées sur les figures.

En référence aux figures, la présente invention concerne un procédé d'installation d'un module de commutation 1 dans une armoire électrique 2 au moyen d'un kit d'installation 3 spécifique permettant de rendre ledit module de commutation 1 facilement démontable et interchangeable par une seule personne en moins d'une demi-heure et avec un simple chariot de manutention 4, sans avoir besoin d'un engin de levage, d'un chariot élévateur, d'un gerbeur ou similaire.

Le module de commutation 1 selon l'invention est un module standard auquel on a ajouté quelques aménagements extérieurs qui seront décrits plus loin et qui peuvent être rapportés sur tout module de commutation neuf ou déjà en service. L'électronique de puissance qu'il contient n'étant pas concernée par l'invention n'est pas représentée, ni décrite. Le module de commutation 1 comporte un boitier 5 parallélépipédique défini par une face avant 6, une face arrière 7, une face latérale droite 8, une face latérale gauche 9, une face inférieure 10 et une face supérieure 11. Il comporte des bornes de raccordement distales 12 et des bornes de raccordement latérales 13, accessibles à l'extérieur du boitier 5 et disposées dans l'exemple représenté au niveau respectivement de la face arrière 7 et de la face gauche 9 du boitier 5. Elles sont destinées à être connectées respectivement à au moins une entrée ou source de courant et à au moins une charge ou sortie de courant. Dans l'exemple représenté, les bornes de raccordement distales 12 sont destinées à être connectées à deux sources de courant à savoir une source principale et une source auxiliaire ou de secours, s'agissant d'un module de transfert statique (STS). Bien entendu, la répartition des bornes de raccordement 12, 13 peut varier selon les installations électriques. Le nombre de bornes de raccordement 12, 13 est fonction de la présence ou non d'un neutre et d'une terre dans l'installation électrique. En l'espèce, il s'agit d'une installation triphasée avec neutre et chaque zone d'entrée et de sortie du courant comporte trois bornes de raccordement pour les trois phases de l'installation L1, L2, L3 et une borne de raccordement pour le neutre N.

Dans le module de commutation 1 selon l'invention, les bornes de raccordement 12, 13 sont constituées de barres conductrices 12', 13', par exemple en cuivre, orientées verticalement et saillantes perpendiculairement de la face supérieure 11 du boitier 5. Elles sont respectivement confondues dans deux plans verticaux, dont un plan vertical distal et un plan vertical latéral qui sont perpendiculaires entre eux. Elles comportent en outre des perforations 14 pour recevoir des organes de fixation décrits plus loin. Le module de commutation 1 selon l'invention comporte des pieds 15 situés en dessous de la face inférieure 10 du boitier 5. Il comporte également des roulettes 16 disposées en deux rangées à la base des faces latérales droite 8 et gauche 9 du boitier 5. Les roulettes 16 sont situées à l'extérieur des pieds 15 et du boitier 5. Elles peuvent être disposées à un niveau différent de celui des pieds 15 et par exemple à un niveau inférieur. Il peut comporter un ou plusieurs raidisseurs 17 surtout ou partie de ses faces et notamment sur chacune de ses faces latérales droite 8 et gauche 9 pour lui conférer une rigidité dimensionnelle durant sa manutention. Il comporte en outre des pattes de fixation frontales 18 qui s'étendent dans le prolongement de la face avant 6 à droite et à gauche du boitier 5. Elles sont au nombre de quatre, deux en partie inférieure et deux en partie supérieur du boitier 5, ce nombre n'étant pas limitatif. Le module de commutation 1 est enfin équipé de poignées 19 disposées sur la face avant 6 du boitier 5, en partie médiane, pour pouvoir déplacer ledit module par poussée ou traction.

L'armoire électrique 2 selon l'invention est une armoire standard dans laquelle on a monté un kit d'installation 3 qui sera décrit plus loin et qui peut être rapporté dans toute armoire électrique neuve ou déjà en service. L'armoire électrique 2 comporte au moins un logement 20 parallélépipédique pour recevoir ledit module de commutation 1, défini par une ouverture frontale 21 fermée par une porte (non représentée), une face arrière 22, une face latérale droite 23, une face latérale gauche 24, une face inférieure 25 et une face supérieure 26. Étant donné que seul ce logement 20 présente un intérêt pour l'invention, les autres parties de l'armoire électrique 2 ne sont pas représentées, ni décrites. Elle comporte traditionnellement des conducteurs électriques (non représentés) respectivement en provenance d'au moins une entrée ou source de courant, et dans l'exemple décrit de deux sources de courant, à savoir une source principale et une source auxiliaire ou de secours, et à destination d'au moins une charge ou sortie de courant. Bien entendu, le nombre de conducteurs électriques prévu dans le logement 20 de l'armoire électrique 2 et le nombre de bornes de raccordement 12, 13 prévu sur le module de commutation 1 sont identiques.

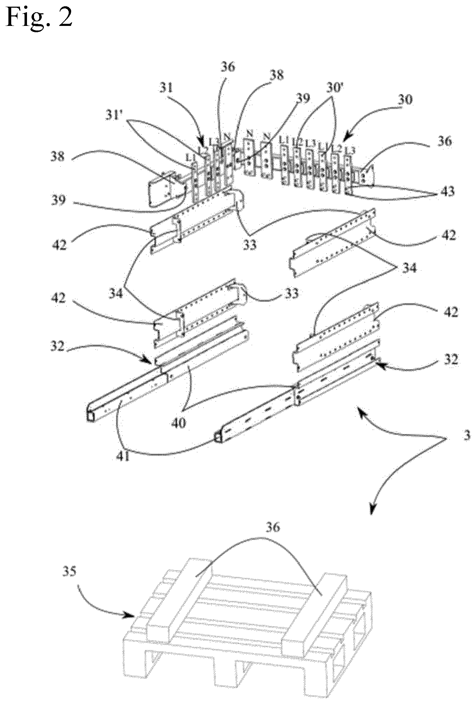

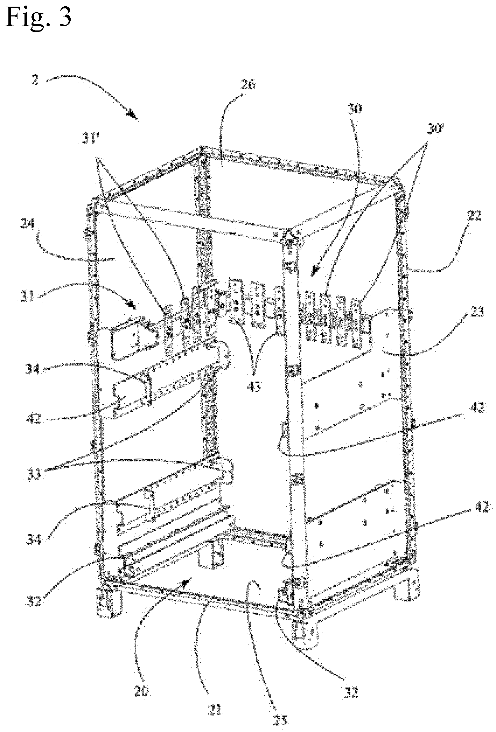

Le kit d'installation 3 selon l'invention comporte en référence aux figures 2 et 3 :
- une plage de raccordement distale 30 pour les entrées du courant,
- une plage de raccordement latérale 31 pour les sorties du courant,
- des rails de support 32 extensibles,
- des butées de fin de course 33 et des pattes de fixation latérales 34,
- et une palette de transport 35 rehaussée.

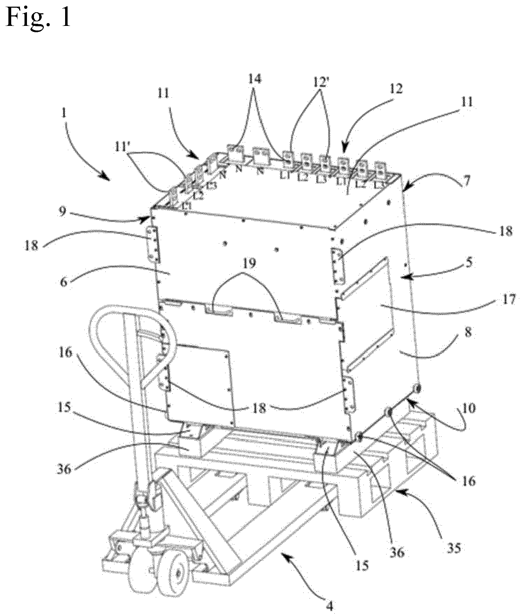

La palette de transport 35 selon l'invention est une palette standard qui a été rehaussée par un aménagement spécial, conformément aux figures 1 et 2, pour transporter de manière sûre le module de commutation 1 à une hauteur déterminée. Elle comporte dans l'exemple représenté deux longerons 36 parallèles, ajoutés sur le plateau de réception de la palette de transport 35, pour recevoir les pieds 15 du module de commutation 1. Tout autre système de rehausse peut convenir, tel qu'un sur-plateau ou un support en forme de treillis. Les pieds 15 sont fixés sur lesdits longerons 36 par des vis ou tout organe de fixation démontable. La hauteur des longerons 36 est déterminée en fonction de la hauteur d'installation du module de commutation 1 dans l'armoire électrique 2 pour éviter le recours à un engin de levage ou chariot élévateur, autre qu'un chariot de manutention 4 dont la hauteur de levage est généralement limitée à 200mm. À l'instar des autres palettes de transport, elle peut être déplacée sans effort par un chariot de manutention 4 tel qu'un transpalette. Bien entendu, la palette de transport 35 peut être conçue spécialement à la hauteur souhaitée.

Les autres éléments du kit d'installation 3 sont mis en place dans le logement 20 prévu à cet effet dans l'armoire électrique 2 conformément à la figure 3.

Les plages de raccordement 30 et 31 comportent chacune au moins un profilé de support isolant 37 sur lequel sont fixées des barres conductrices 30', 31', perpendiculairement audit profilé 37. Chaque barre conductrice 30', 31' est reliée à un conducteur électrique (non représenté) d'une source d'énergie ou d'une charge par tout moyen de fixation approprié, tel qu'une cosse et une vis. La plage de raccordement distale 30 dédiée aux entrées du courant est positionnée contre ou à proximité de la face arrière 22 du logement 20, de telle sorte que les barres conductrices 30' correspondantes s'étendent verticalement et sont confondues dans un même plan vertical distal. Et la plage de raccordement latérale 31 dédiée aux sorties du courant est positionnée contre ou à proximité de la face latérale gauche 24 du logement 20, de telle sorte que les barres conductrices 31 ' s'étendent verticalement et sont confondues dans un même plan vertical latéral, perpendiculaire au plan vertical distal.

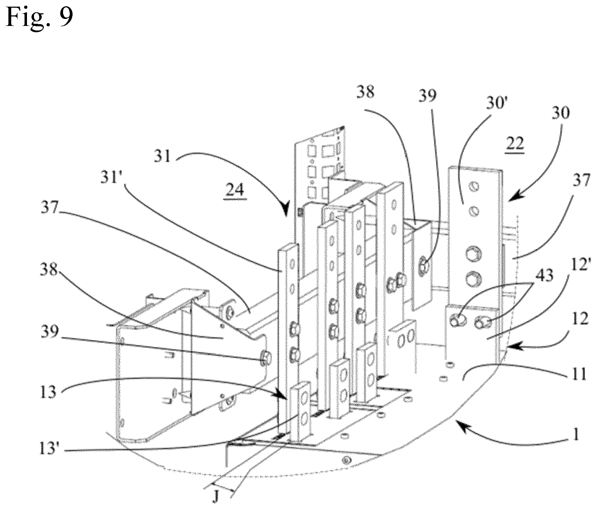

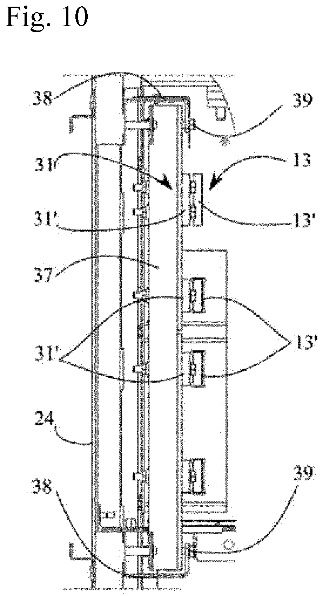

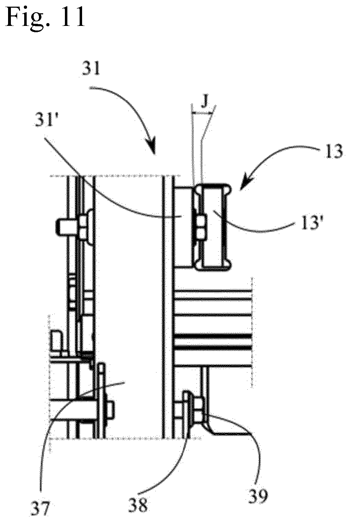

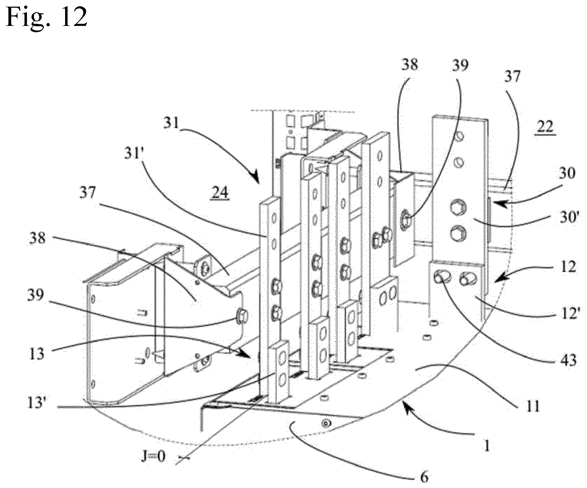

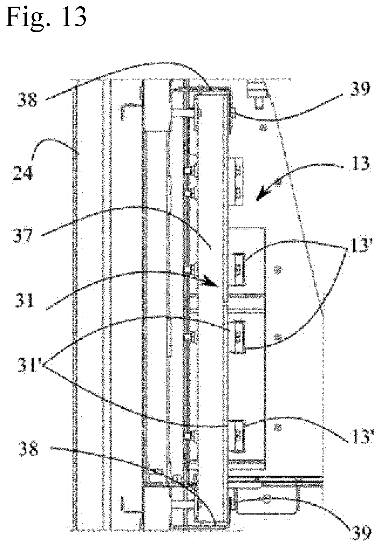

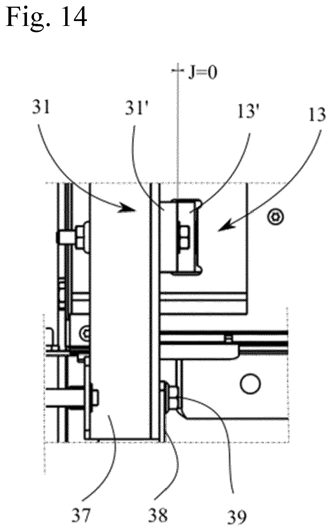

En outre, la plage de raccordement latérale 31 est fixée sur deux étriers 38 par des vis de fixation 39 qui permettent de déplacer ladite plage de raccordement latérale 31 entre une position initiale et une position escamotée générant un jeu de montage J. Dans la position initiale (fig. 12 à 14), les vis de fixation 39 sont serrées et la plage de raccordement latérale 31 est avancée pour être en contact avec les bornes de raccordement latérales 13 correspondantes du module de commutation 1, et fermer le circuit électrique. Dans la position escamotée (fig. 9 à 11), les vis de fixation 39 sont desserrées, permettant à l'opérateur de pousser la plage de raccordement latérale 31 vers la gauche, pour l'éloigner des bornes de raccordement latérales 13 correspondantes du module de commutation 1, ouvrir le circuit électrique et ménager un jeu de montage J, autorisant les déplacements du module de commutation 1 par rapport à l'armoire électrique 2 sans obstacle. Bien entendu, tout autre moyen permettant de déplacer la plage de raccordement latérale 31 entre ses positions initiale et escamotée peut convenir. Un organe ressort peut en outre être ajouté dans les étriers 38 sous les vis de fixation 39 pour déplacer automatiquement la plage de raccordement latérale 31 de sa position initiale à sa position escamotée ou inversement en fonction du serrage et du desserrage desdites vis de fixation 39.

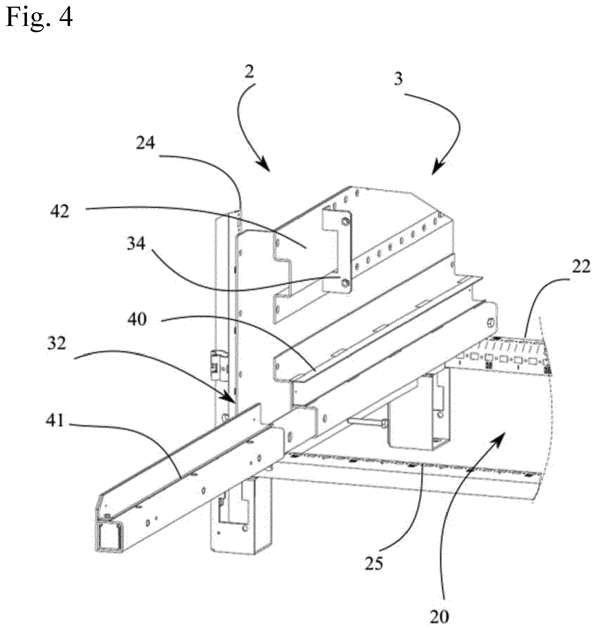

Les rails de support 32 extensibles sont, dans l'exemple représenté, au nombre de deux et sont rapportés dans la partie inférieure du logement 20 prévu dans l'armoire électrique 2, sur ses faces latérales droite 23 et gauche 24. Ils sont disposés en opposition et parallèles entre eux pour former deux chemins de roulement sur lesquels peuvent circuler les roulettes 16 du module de commutation 1 pendant ses déplacements par rapport à ladite armoire. Chaque rail de support 32 comporte une partie fixe 40 et une partie mobile 41 qui peut coulisser par rapport à partie fixe 40. La partie fixe 40 s'étend sur la largeur desdites faces latérales 23, 24, correspondant à la profondeur du logement 20. Et la partie mobile 41 peut coulisser entre une position rétractée (fig. 3) dans laquelle elle est logée entièrement dans la partie fixe 40 et une position étendue (fig. 2, 4 et 5) dans laquelle elle est saillante de la partie fixe et s'étend en dehors du logement 20, à l'extérieur de l'armoire électrique 2. La partie mobile 41 du rail de support 32 comporte une section en L pour guider latéralement lesdites roulettes 16 du module de commutation 1. La partie fixe 40 du rail de support 32 comporte une section en C pour guider latéralement et verticalement lesdites roulettes 16. Les rails de support 32 comportent entre la partie fixe 40 et la partie mobile 41 un guidage linéaire à galets et à billes selon les exigences de charges.

Les butées de fin de course 33 et les pattes de fixation latérales 34 sont, dans l'exemple représenté, fixées sur des profilés 42 rapportés sur les faces latérales droite 23 et gauche 24 du logement 20 prévu dans l'armoire électrique 2. Ces profilés 42 sont au nombre de quatre, répartis deux à deux en partie inférieure et en partie supérieures du logement 20, en opposition et parallèles entre eux. Les butées de fin de course 33 sont au nombre de quatre et positionnées dans le fond du logement 20, à proximité de la face arrière 22. Elles ont pour fonction d'arrêter le module de commutation 1 lorsqu'il est introduit dans l'armoire électrique 2 et de définir la position montée dudit module dans laquelle les bornes de raccordement distales 12 sont en contact électrique avec la plage de raccordement distale 30. Les pattes de fixation latérales 34 sont au nombre de quatre et positionnées à l'avant du logement 20, à distance des butées de fin de course 33 correspondant à la profondeur du module de commutation 1. Elles ont pour fonction de fixer le module de commutation 1 via ses pattes de fixation frontales 18 à l'armoire électrique 2 et d'empêcher tout déplacement relatif accidentel dudit module par rapport à l'armoire, notamment en cas de séisme. Bien entendu, les butées de fin de course 33 et les pattes de fixation latérales 34 peuvent présenter d'autres formes, et être fixées et/ou réparties dans l'armoire électrique 2 différemment, dans la mesure où elles sont compatibles avec le module de commutation 1.

Le procédé d'installation selon l'invention consiste à équiper le logement 20 d'une armoire électrique 2 au moyen d'un kit d'installation 3 selon l'invention, en respectant des hauteurs et des emplacements déterminés par rapport au module de commutation 1 à installer (fig. 3). Lorsqu'elles sont installées, les plages de raccordement distale 30 et frontale 31 doivent être raccordées aux conducteurs électriques correspondants prévus dans l'armoire électrique 2 et non représentés.

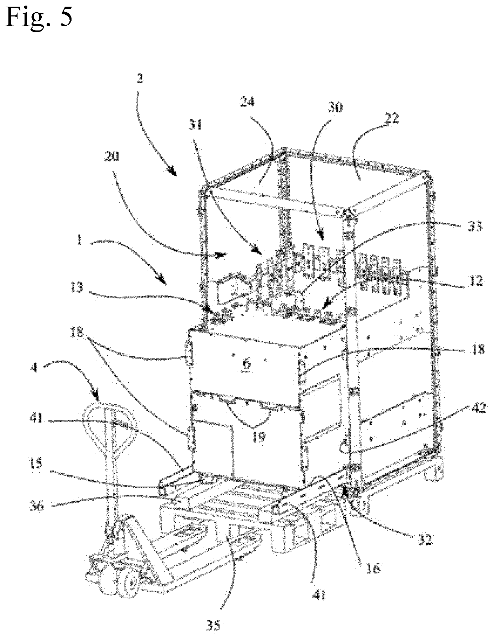

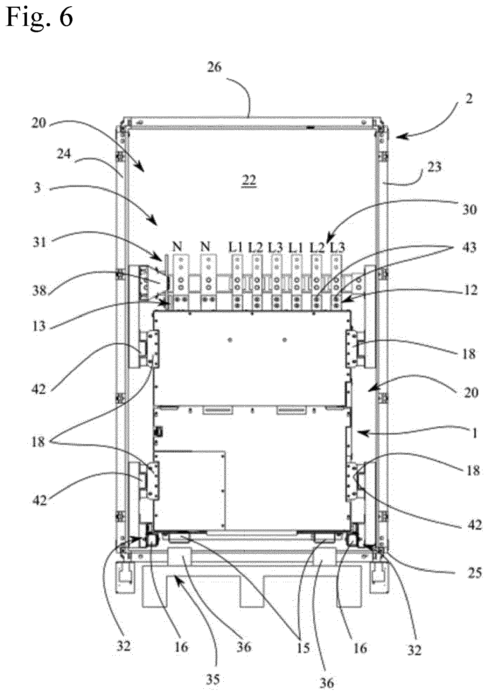

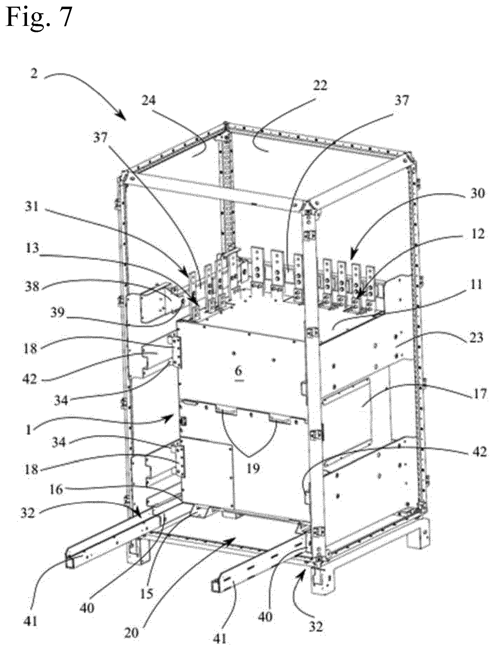

En référence à la figure 1, le module de commutation 1 est positionné sur une palette de transport 35 selon l'invention. Les pieds 15 du module de commutation 1 peuvent être fixés sur les longerons 36 correspondants (fig. 1). L'ensemble « module de commutation 1 et palette de transport 35 » ainsi constitué forme un tout rigide qui peut être manutentionné en toute sécurité par un chariot de manutention 4 traditionnel équipé de fourches. Les fourches du chariot de manutention 4 permettent de prélever la palette de transport 35 et de la surélever légèrement (hauteur de levage inférieure ou égale à 200mm) pour pouvoir déplacer ledit module de commutation 1 et l'amener devant le logement 20 prévu dans l'armoire électrique 2 (fig. 5). Préalablement, la partie mobile 41 des rails de support 32 a été déplacée de sa position rétractée à sa position étendue permettant d'accueillir les roulettes 16 du module de commutation 1 à l'extérieur de l'armoire électrique 2. Grâce à la palette de transport 35 rehaussée, les roulettes 16 du module de commutation 1 sont positionnées sensiblement au même niveau que les chemins de roulement définis par les rails de support 32. Les fourches du chariot de manutention 4 sont abaissées pour déposer le module de commutation 1 sur les rails de support 32 via ses roulettes 16. Les vis de fixation des pieds 15 du module de commutation 1 sont dévissées et retirées pour désolidariser le module de commutation 1 de la palette de transport 35, laquelle est évacuée au moyen dudit chariot de manutention 4. Le module de communication 1 repose alors exclusivement sur la partie mobile 41 des rails de support 32 (fig 6 et 7). Il peut ensuite être simplement poussé en direction du fond du logement 20 en exerçant un minimum d'effort de poussée puisqu'il roule sur les chemins de roulement des parties mobiles 41 puis ceux des parties fixes 40 des rails de support 32. Préalablement, les vis de fixation 39 de la plage de raccordement latérale 31 sur les étriers 38 ont été dévissées pour déplacer ladite plage de sa position initiale à sa position escamotée afin de ménager un jeu de montage J autorisant l'introduction dudit module de commutation 1 dans l'armoire électrique 2. Lorsque ledit module de commutation 1 arrive dans sa position montée, définie par les butées de fin de course 33, il peut être verrouillé en position, en assemblant par des vis de fixation ses pattes de fixation frontales 18 superposées aux pattes de fixation latérales 34 prévues dans le logement 20. Dans cette position montée, les bornes de raccordement distales 12 du module de commutation 1 sont en contact plan avec la plage de raccordement distale 30 qui équipe l'armoire électrique 2. Les barres conductrices 12' et 30' correspondantes sont superposées, en contact électrique l'une avec l'autre et peuvent être fixées par tout moyen approprié, tel que des écrous serrés sur des plots 43 prévus sur les barres conductrices 30' de la plage de raccordement distale 30. Les vis de fixation 39 qui retiennent la plage de raccordement latérale 31 sur ses étriers 38 peuvent être vissées pour ramener ladite plage dans sa position initiale mettant en contact plan la plage de raccordement latérale 31 avec les bornes de raccordement 13 correspondantes du module de commutation 1. Les barres conductrices 13' et 31' correspondantes sont superposées, en contact électrique l'une avec l'autre et peuvent être fixées par tout moyen approprié, tel que des écrous serrés sur des plots 43 prévus sur les barres conductrices 31' de la plage de raccordement latérale 31. Tout autre moyen de connexion électrique démontable peut convenir. Le module de commutation 1 est par conséquent installé et raccordé électriquement dans une armoire électrique 2 de manière simple, rapide, sans effort, en peu de temps par un seul opérateur, en toute sécurité, avec un simple chariot de manutention 4 à fourches, et sans recourir à un engin de levage, chariot élévateur ou similaire. Pour effectuer une opération de maintenance sur ledit module de commutation 1, il convient de procéder en sens inverse pour déconnecter électriquement le module de commutation 1 de l'armoire électrique 2, déplacer la plage de raccordement latérale 31 de sa position initiale à sa position escamotée, déplacer les parties mobiles 41 des rails de support 32 de leur position rétractée à leur position étendue, déplacer le module de commutation 1 par traction pour le faire rouler sur les chemins de roulement des rails de support 32, l'extraire de son logement 20 et l'amener à l'extérieur de l'armoire électrique 2, positionner sous le module de commutation 1 une palette de transport 35 rehaussée au moyen d'un chariot de manutention 4, élever légèrement la palette de transport 35 pour entrer en contact avec les pieds 15, fixer les pieds 15 sur les longerons 36, reculer le chariot de manutention 4 jusqu'à ce que les roulettes 16 quittent les rails de support 32, et transporter le module de commutation 1 vers une zone de maintenance ou autre. Le procédé d'installation selon l'invention permet d'accéder, de réparer ou de remplacer le module de commutation 1 de manière optimisée et ergonomique, avec un simple chariot de manutention.

La présente invention n'est bien entendu pas limitée à l'exemple de réalisation décrit mais s'étend à toute modification et variante évidentes pour un homme du métier dans la limite des revendications annexées.

## Revendications

1. Procédé d'installation d'un module de commutation (1) lourd et encombrant, notamment un commutateur de transfert statique (STS), dans une armoire électrique (2), dans lequel l'on installe ledit module de commutation (1) dans ladite armoire électrique (2) au moyen d'un kit d'installation (3) pour rendre ledit module de commutation (1) facilement démontable et interchangeable quel que soit son encombrement et son poids, et éviter le recours à un engin de levage, procédé dans lequel l'on équipe ladite armoire électrique (2) avec ledit kit d'installation (3) comportant deux rails de support (32) extensibles entre une position étendue à l'extérieur de ladite armoire électrique (2) et une position rétractée à l'intérieur de ladite armoire électrique (2), lesdits rails de support (32) étant agencés pour former deux chemins de roulement parallèles, dans lequel l'on équipe ledit module de commutation (1) avec des roulettes (16) disposées en deux rangées parallèles, agencées pour circuler sur lesdits chemins de roulement de manière à pouvoir déplacer ledit module de commutation (1) de l'extérieur vers l'intérieur de ladite armoire électrique (2) et inversement par poussée et traction avec un minimum d'efforts, et dans lequel l'on utilise une palette de transport (35) rehaussée faisant partie dudit kit d'installation pour manutentionner ledit module de commutation (1) en dehors de ladite armoire électrique (2) au moyen d'un chariot de manutention (4), de sorte que les roulettes (16) dudit module de commutation (1), lorsqu'il est pris en charge par ladite palette de transport (35), sont positionnées sensiblement au même niveau que les chemins de roulement définis par lesdits rails de support (32) pour permettre le transfert dudit module de commutation (1) par roulement de la palette de transport (35) à l'armoire électrique (2) et inversement.

2. Procédé d'installation selon la revendication 1, **caractérisé en ce que** l'on équipe ladite palette de transport (35) de longerons (36), **en ce que** l'on fixe ledit module de commutation (1) sur lesdits longerons (36) au moyen de pieds (15) disposés sous ledit module de commutation (1) entre les deux rangées de roulettes (16), et **en ce que** l'on détermine la hauteur desdits longerons (36) en fonction du niveau d'installation desdits rails de support (32) dans ladite armoire électrique (2).

3. Procédé d'installation selon l'une quelconque des revendications précédentes, **caractérisé en ce que** l'on prévoit dans ledit kit d'installation (3) une plage de raccordement distale (30) et une plage de raccordement latérale (31) formant deux plans d'appui verticaux perpendiculaires, **en ce que** l'on fixe lesdites plages de raccordement (30, 31) dans ladite armoire électrique (2) respectivement sur une face arrière (22) et sur une des faces latérales (23, 24) intérieures de ladite armoire électrique (2), **en ce que** l'on y raccorde des conducteurs électriques formant des entrées et des sorties du courant, **en ce que** l'on équipe ledit module de commutation (1) de bornes de raccordement distales (12) et des bornes de raccordement latérales (13) formant deux plans d'appui verticaux perpendiculaires, et **en ce que** l'on fixe ladite plage de raccordement latérale (31) sur des étriers (38) pour qu'elle soit mobile entre une position initiale correspondant à une position connectée avec les bornes de raccordement latérales (13) dudit module de commutation (1), et une position escamotée correspondant à une position déconnectée desdites bornes de raccordement latérales (13) en ménageant un jeu de montage (1) qui autorise le déplacement dudit module de commutation (1) par rapport à ladite armoire électrique (2).

4. Procédé d'installation selon l'une quelconque des revendications précédentes, **caractérisé en ce que** l'on prévoit dans ledit kit d'installation (3) des pattes de fixation latérales (34) rapportées sur les faces latérales (23, 24) intérieures de ladite armoire électrique (2), **en ce que** l'on équipe ledit module de commutation (1) de pattes de fixation frontales (18), et **en ce que**, lorsque ledit module de commutation (1) est en position montée dans ladite armoire électrique (2), on le verrouille en position montée, en fixant les pattes de fixation frontales (18) sur les pattes de fixation latérales (34) correspondantes prévues dans l'armoire électrique (2).

5. Kit d'installation (3) d'un module de commutation (1), notamment un commutateur de transfert statique (STS), dans une armoire électrique (2), **caractérisé en ce qu'**il permet la mise en oeuvre du procédé d'installation selon l'une quelconque des revendications précédentes, **en ce qu'**il comporte deux rails de support (32) agencés pour équiper ladite armoire électrique (2), lesdits rails de support (32) étant extensibles entre une position étendue et une position rétractée pour former deux chemins de roulement parallèles pour ledit module de commutation (1), et **en ce qu'**il comporte une palette de transport (35) rehaussée agencée pour manutentionner ledit module de commutation (1) en dehors de ladite armoire électrique (2) au moyen d'un chariot de manutention, sans avoir recours à un engin de levage, de sorte que les roulettes (16) du module de commutation (1) sont positionnées sensiblement au même niveau que les chemins de roulement définis par les rails de support (32).

6. Kit d'installation selon la revendication 5, **caractérisé en ce que** ladite palette de transport (35) comporte deux longerons (36) sur lesquels est destiné à être fixé ledit module de commutation (1), et **en ce que** lesdits longerons (36) ont une hauteur déterminée en fonction du niveau d'installation des rails de support (32) dans ladite armoire électrique.

7. Kit d'installation selon l'une quelconque des revendications 5 et 6, **caractérisé en ce qu'**il comporte une plage de raccordement distale (30) et une plage de raccordement latérale (31) formant deux plans d'appui verticaux perpendiculaires, lesdites plages de raccordement (30, 31) étant agencées pour équiper ladite armoire électrique (2), et **en ce que** ladite plage de raccordement latérale (31) est montée sur des étriers (38) pour être mobile entre une position initiale et une position escamotée, séparées entre-elles d'un jeu de montage (J).

8. Kit d'installation selon l'une quelconque des revendications 5 à 7, **caractérisé en ce qu'**il comporte des pattes de fixation latérales (34) agencées pour équiper ladite armoire électrique (2) et verrouiller ledit module de commutation (1) en position montée lorsqu'il est installé dans ladite armoire électrique (2).

9. Module de commutation (1), notamment un commutateur de transfert statique (STS), agencé pour être installé dans une armoire électrique (2), permettant la mise en oeuvre du procédé d'installation selon l'une quelconque des revendications 1 à 4 au moyen du kit d'installation selon l'une quelconque des revendications 5 à 8, ledit module de commutation (1) comportant des roulettes (16) disposées en deux rangées parallèles et agencées pour circuler sur des chemins de roulement formés par des rails de support (32) extensibles rapportés dans ladite armoire électrique (2), et des pieds (15) disposés sous ledit module et agencés pour fixer ledit module de commutation (1) sur une palette de transport (35) rehaussée de sorte que les roulettes (16) dudit module de commutation (1) sont positionnées sensiblement au même niveau que les chemins de roulement définis par lesdits rails de support (32), lesdits pieds (15) étant disposés entre lesdites rangées de roulettes (16).

10. Module de commutation selon la revendication 9, **caractérisé en ce qu'**il comporte des bornes de raccordement distales (12) et des bornes de raccordement latérales (13) saillantes en partie supérieure dudit module et disposées pour former deux plans d'appui verticaux perpendiculaires, lesdites bornes de raccordement (12, 13) étant agencées pour être connectées aux plages de raccordement distale (30) et latérale (31) rapportées dans ladite armoire électrique (2) lorsque ledit module de commutation (1) est installé dans ladite armoire électrique (2).

11. Module de commutation selon l'une quelconque des revendications 9 et 10, **caractérisé en ce qu'**il comporte des pattes de fixation frontales (18) agencées pour être assemblées à des pattes de fixation latérales (34) correspondantes rapportées dans ladite armoire électrique (2) lorsque ledit module de commutation (1) est installé dans ladite armoire électrique (2).

## Patentansprüche

1. Verfahren zur Installation eines schweren und sperrigen Schaltmoduls (1), insbesondere eines statischen Transferschalters (STS), in einem Schaltschrank (2), bei dem dieses Schaltmodul (1) in diesem Schaltschrank (2) mittels eines Installationssets (3) installiert wird, damit dieses Schaltmodul (1) leicht demontierbar und austauschbar ist, ungeachtet seines Platzbedarfs und seines Gewichts und um den Einsatz einer Hebevorrichtung zu vermeiden, ein Verfahren, bei dem dieser Schaltschrank (2) mit diesem Installationsset (3) ausgerüstet wird, das zwei Tragschienen (32) enthält, die zwischen einer ausgezogenen Position an der Außenseite dieses Schaltschranks (2) und einer eingezogenen Position an der Innenseite dieses Schaltschranks (2) verschiebbar sind, diese Tragschienen (32) sind dazu vorgesehen, zwei parallele Laufbahnen zu bilden, in denen dieses Schaltmodul (1) mit Rollen (16), angeordnet in zwei parallelen Reihen, ausgerüstet wird, die so ausgelegt sind, dass sie sich auf diesen Laufbahnen zu bewegen, so dass sie das erwähnte Schaltmodul (1) von der Außenseite zur Innenseite dieses Schaltschranks (2) und umgekehrt verschieben können, durch Druck und Zug mit einem Minimum an Kraftaufwand und bei dem eine erhöhte Transportpalette (35) eingesetzt wird, die zu diesem Installationsset gehört, um das erwähnte Schaltmodul (1) außerhalb dieses elektrischen Schaltschranks (2) mittels eines Transportkarrens (4) zu transportieren, so dass die Rollen (16) dieses Schaltmoduls (1), wenn es von dieser Transportpalette (35) übernommen wird, im Wesentlichen in derselben Höhe positioniert sind, wie die durch diese Tragschienen (32) definierten Laufbahnen, um die Verlagerung des erwähnten Schaltmoduls (1) durch Rollen der Transportpalette (35) zum elektrischen Schaltschrank (2) und umgekehrt, zu ermöglichen.

2. Installationsverfahren nach Anspruch 1, **dadurch gekennzeichnet, dass** die erwähnte Transportpalette (35) mit Längsträgern (36) ausgerüstet ist, dass das erwähnte Schaltmodul (1) auf diesen Längsträgern (36) mittels Füßen (15) befestigt ist, die unter diesem Schaltmodul (1) zwischen den beiden Rollenreihen (16) angeordnet sind, und dass die Höhe dieser Längsträger (36) in Abhängigkeit von der Installationshöhe dieser Tragschienen (32) in diesem Schaltschrank (2) bestimmt wird.

3. Installationsverfahren nach irgendeinem der vorstehenden Ansprüche, **dadurch gekennzeichnet, dass** in dem erwähnten Installationsset (3) ein distaler Anschlussbereich (30) und ein lateraler Anschlussbereich (31) vorgesehen sind, die zwei vertikale, senkrechte Auflageflächen bilden, dadurch, dass diese Anschlussbereiche (30, 31) in diesem Schaltschrank (2) jeweils auf einer Rückseite (22) und auf einer der inneren Seitenflächen (23, 24) dieses Schaltschrank (2) befestigt werden, dadurch, dass dort elektrische Leitungen angeschlossen werden, die Stromeingänge und -ausgänge bilden, dadurch, dass das erwähnte Schaltmodul (1) mit distalen Anschlussklemmen (12) und seitlichen Anschlussklemmen (13) ausgerüstet wird, die zwei vertikale, senkrechte Auflageflächen bilden, und dadurch, dass der erwähnte seitliche Anschlussbereich (31) auf Bügeln (38) befestigt wird, damit er beweglich ist zwischen einer Ausgangsposition, die einer angeschlossenen Position entspricht, verbunden mit den seitlichen Anschlussklemmen (13) dieses Schaltmodul (1) und einer ausgeklappten Position, die einer getrennten Position dieser seitlichen Anschlussklemmen (13) entspricht, wobei ein Montagesatz (J) ausgespart wird, der die Verschiebung dieses Schaltmoduls (1) gegenüber dem erwähnten Schaltschrank (2) erlaubt.

4. Installationsverfahren nach irgendeinem der vorstehenden Ansprüche, **dadurch gekennzeichnet, dass** in diesem Installationsset (3) seitliche Befestigungslaschen (34) vorgesehen sind, angebracht auf den inneren Seitenflächen (23, 24) des erwähnten Schaltschranks (2), dadurch, dass das erwähnte Schaltmodul (1) mit frontalen Befestigungslaschen (18) ausgerüstet ist, und dadurch, dass wenn sich das Schaltmodul (1) in der in diesem Schaltschrank (2) montierten Position befindet, es in der montierten Position verriegelt wird, indem die frontalen Befestigungslaschen (18) an den entsprechenden seitlichen Befestigungslaschen (34) vorgesehen im Schaltschrank (2) befestigt werden.

5. Installationsset (3) für ein Schaltmodul (1), insbesondere einen statischen Transferschalter (STS), in einem Schaltschrank (2), **dadurch gekennzeichnet, dass** es die Durchführung eines Installationsverfahrens nach irgendeinem der vorstehenden Ansprüche ermöglicht, dass es zwei Tragschienen (32) enthält, ausgelegt zur Ausrüstung des Schaltschrankes (2), diese Tragschienen (32) sind dabei ausziehbar zwischen einer ausgezogenen Position und einer eingezogenen Position, um zwei parallele Laufbahnen für dieses Schaltmodul (1) zu bilden, und dadurch, dass es eine erhöhte Transportpalette (35) enthält, vorgesehen zum Transport dieses Schaltmoduls (1) außerhalb des erwähnten Schaltschranks (2) mittels einen Transportkarrens, ohne Einsatz einer Hebevorrichtung, so dass die Rollen (16) des Schaltmoduls (1) im Wesentlichen in derselben Höhe positioniert sind wie die durch die Tragschienen (32) definierten Laufbahnen.

6. Installationsset nach Anspruch 5, **dadurch gekennzeichnet, dass** die erwähnte Transportpalette (35) zwei Längsträger (36) enthält, auf denen das erwähnte Schaltmodul (1) befestigt werden soll, und dadurch, dass diese Längsträger (36) eine Höhe haben, die in Abhängigkeit von der Installationshöhe der Tragschienen (32) in diesem Schaltschrank bestimmt wird.

7. Installationsset nach irgendeinem der vorstehenden Ansprüche 5 und 6, **dadurch gekennzeichnet, dass** es einen distalen Anschlussbereich (30) und einen seitlichen Anschlussbereich (31) enthält, die zwei vertikale, senkrechte Auflageflächen bilden, dadurch dass diese Anschlussbereiche (30, 31) zur Ausrüstung dieses Schaltschranks (2) vorgesehen sind und dadurch, dass dieser seitliche Anschlussbereich (31) auf Bügeln (38) montiert ist, um zwischen einer Ausgangsposition und einer ausgeklappten Position beweglich zu sein, die voneinander durch einen Montagesatz (J) getrennt sind.

8. Installationsset nach irgendeinem der vorstehenden Ansprüche 5 bis 7, **dadurch gekennzeichnet, dass** es seitliche Befestigungslaschen (34) enthält, ausgelegt zur Ausrüstung dieses Schaltschrankes (2) und zur Verriegelung dieses Schaltmoduls (1) in der montierten Position, wenn es in diesem Schaltschrank (2) installiert ist.

9. Schaltmodul (1), insbesondere ein statischer Transferschalter (STS), vorgesehen zur Installation in einem Schaltschrank (2), das die Umsetzung des Installationsverfahrens nach irgendeinem der vorstehenden Ansprüche 1 bis 4 mittels des Installationssets, nach irgendeinem der vorstehenden Ansprüche 5 bis 8 ermöglicht, dieses Schaltmodul (1) enthält Rollen (16), angeordnet in zwei parallelen Reihen und vorgesehen um sich auf den Laufbahnen zu bewegen, gebildet von ausziehbaren Tragschienen (32), eingebaut in diesem Schaltschrank (2), und Füße (15), angeordnet unter diesem Modul und dazu vorgesehen, dieses Schaltmodul (1) auf einer erhöhten Transportpalette (35) zu befestigen, so dass die Rollen (16) dieses Schaltmoduls (1) im Wesentlichen in derselben Höhe wie die durch dieses Tragschienen (32) definierten Laufbahnen positioniert sind, die erwähnten Füße (15) sind zwischen diesen Rollenreihen (16) angeordnet.

10. Schaltmodul nach Anspruch 9, **dadurch gekennzeichnet, dass** es distale Anschlussklemmen (12) und seitliche Anschlussklemmen (13) enthält, die im oberen Teil dieses Moduls hervorragen und angeordnet zur Bildung von zwei vertikalen, senkrechten Auflageflächen, diese Anschlussklemmen (12, 13) sind dazu vorgesehen, um mit den in diesem Schaltschrank (2) eingebauten distalen (30) und seitlichen (31) Anschlussbereichen verbunden zu werden, wenn dieses Schaltmodul (1) in diesem Schaltschrank (2) installiert ist.

11. Schaltmodul nach irgendeinem der vorstehenden Ansprüche 9 und 10, **dadurch gekennzeichnet, dass** es frontale Befestigungslaschen (18) enthält, ausgelegt zur Verbindung mit entsprechenden seitlichen Befestigungslaschen (34), eingebaut in diesem Schaltschrank (2) wenn dieses Schaltmodul (1) in diesem Schaltschrank (2) installiert ist.

## Claims

1. A method for installing a heavy and bulky switching module (1), in particular a static transfer switch (STS), in an electrical cabinet (2), wherein said switching module (1) is installed in said electrical cabinet (2) by means of an installation kit (3) to make said switching module (1) easily removable and interchangeable, regardless of its size and weight, and avoid the need for a lifting device, method in which said electrical cabinet (2) is equipped with said installation kit (3) comprising two support rails (32), extendable between an extended position outside of said electrical cabinet (2) and a retracted position inside said electrical cabinet (2), said support rails (32) being arranged to form two parallel rolling paths, wherein said switching module (1) is equipped with rollers (16) arranged in two parallel rows, designed to circulate on said rolling paths so as to be able to move said switching module (1) from the outside to the inside of said electrical cabinet (2), and vice versa, by pushing and pulling with minimal effort, and wherein a raised transport pallet (35), forming part of said installation kit, is used to handle said switching module (1) outside said electrical cabinet (2) by means of an industrial truck (4), so that the wheels (16) of said switching module (1), when supported by said transport pallet (35), are positioned substantially at the same level as the roller paths defined by said support rails (32) in order to allow the transfer of said switching module (1) by rolling it from the transport pallet (35) to the electrical cabinet (2) and vice versa.

2. The installation method according to claim 1, **characterized in that** said transport pallet (35) is fitted with spars (36), **in that** said switching module (1) is fixed on said spars (36) by means of feet (15) arranged under said switching module (1) between the two rows of rollers (16), and **in that** the height of said spars (36) is determined according to the level of installation of said support rails (32) in said electrical cabinet (2).

3. The installation method according to any of the preceding claims, **characterized in that** provision is made in said installation kit (3) for a distal connection pad (30) and a lateral connection pad (31) forming two perpendicular vertical support planes, **in that** said connection pads (30, 31) are fixed in said electrical cabinet (2) respectively on a rear face (22) and on one of the inner lateral faces (23, 24) of said electrical cabinet (2), **in that** electrical conductors are connected thereto forming current inputs and outputs, **in that** said switching module (1) is fitted with distal connection terminals (12) and lateral connection terminals (13) forming two perpendicular vertical support planes, and **in that** said lateral connection pad (31) is fixed on brackets (38) so that it is movable between an initial position corresponding to a position connected with the lateral connection terminals (13) of said switching module (1), and a retracted position corresponding to a disconnected position of said lateral connection terminals (13) by providing an assembly clearance (J) which allows movement of said switching module (1) relative to said electrical cabinet (2).

4. The installation method according to any of the preceding claims, **characterized in that** provision is made in said installation kit (3) for lateral mounting lugs (34) added to the inner lateral faces (23, 24) of said electrical cabinet (2), **in that** said switching module (1) is fitted with front mounting lugs (18), and **in that**, when said switching module (1) is in the mounted position in said electrical cabinet (2), it is locked in the mounted position, by fixing the front mounting lugs (18) on the corresponding lateral mounting lugs (34) provided in the electrical cabinet (2).

5. Installation kit (3) of a switching module (1), in particular a static transfer switch (STS), in an electrical cabinet (2), **characterized in that** it allows the implementation of the installation method according to any of the preceding claims, **in that** it comprises two support rails (32) arranged to equip said electrical cabinet (2), said support rails (32) being extendable between an extended position and a retracted position to form two parallel rolling paths for said switching module (1), and **in that** it comprises a raised transport pallet (35), arranged to handle said switching module (1) outside of said electrical cabinet (2) by means of an industrial truck, without resorting to a lifting device, so that the rollers (16) of the switching module (1) are positioned substantially at the same level as the rolling paths defined by the support rails (32).

6. The installation kit according to claim 5, **characterized in that** said transport pallet (35) comprises two spars (36) on which said switching module (1) is intended to be fixed, and **in that** said spars (36) have a height determined according to the installation level of the support rails (32) in said electrical cabinet.

7. The installation kit according to any of claims 5 and 6, **characterized in that** it comprises a distal connection pad (30) and a lateral connection pad (31) forming two perpendicular vertical support planes, said connection pads (30, 31) being arranged to equip said electrical cabinet (2), and **in that** said lateral connection pad (31) is mounted on brackets (38) so as to be movable between an initial position and a retracted position, separated from each other by an assembly clearance (J).

8. The installation kit according to any of claims 5 to 7, **characterized in that** it comprises lateral mounting lugs (34) arranged to equip said electrical cabinet (2) and lock said switching module (1) in the mounted position when installed in said electrical cabinet (2).

9. A switching module (1), in particular a static transfer switch (STS), arranged to be installed in an electrical cabinet (2), allowing the implementation of the installation method according to any of claims 1 to 4 by means of the installation kit according to any of claims 5 to 8, said switching module (1) comprising rollers (16) arranged in two parallel rows and designed to circulate on rolling paths formed by extendable rails support (32) fixed in said electrical cabinet (2), and feet (15) arranged under said module and designed to fix said switching module (1) on a raised transport pallet (35) so that the rollers (16) of said switching module (1) are positioned substantially at the same level as the rolling paths defined by said support rails (32), said feet (15) being arranged between said rows of rollers (16).

10. The switching module according to claim 9, **characterized in that** it comprises distal connection terminals (12) and lateral connection terminals (13) projecting in the upper part of said module and arranged to form two perpendicular vertical support planes, said connection terminals (12, 13) being arranged to be connected to the distal (30) and lateral (31) connection pads added in said electrical cabinet (2) when said switching module (1) is installed in said electrical cabinet (2).

11. The switching module according to any of claims 9 and 10, **characterized in that** it comprises front mounting lugs (18) arranged to be assembled with corresponding lateral mounting lugs (34) added in said electrical cabinet (2) when said switching module (1) is installed in said electrical cabinet (2).
